# EUROPEAN PATENT APPLICATION

(11) **EP 4 797 913 A1**
(43) Date of publication of application: **26.08.2026**
(21) Application number: 24879291.3
(22) Date of filing: 07.11.2024
(51) Int. Cl.: H10F 71/00, H10F 10/17, H10F 77/12, B08B 3/02, B08B 5/02

(54) **METHOD AND APPARATUS FOR MANUFACTURING SOLAR CELLS**

(30) Priority: 18.10.2023 KR 20230139851
(71) Applicant: Hanwha Solutions Corporation, Seoul 04541 (KR)
(72) Inventor: KU, Chan Hoe, Seoul 04541 (KR); CHO, Sang Hyun, Seoul 04541 (KR)
(74) Representative: Mooser, Sebastian Thomas
(86) International application number: PCT/IB2024/061010
(87) International publication number: WO 2025/083670

(57) **Abstract**

A heat treatment apparatus according to one embodiment of the present invention comprises: a process tube in which a heat treatment process is performed therein; a door disposed at one side of the process tube and configured to open and close the process tube; a heater configured to heat the process tube; and a space portion disposed between the process tube and the heater, wherein a flow path through which a refrigerant flows is formed in the space portion, and the flow path is formed in a spiral pipe structure surrounding the process tube.

## Description

### [Technical Field]

Embodiments of the present invention relate to a solar cell manufacturing apparatus and a solar cell manufacturing method.

### [Background Art]

A solar cell is formed by disposing a diode having a p-n junction on a substrate. When sunlight reaches a solar cell, the solar cell creates an exciton, that is, an electron-hole pair, and the exciton splits into electrons and holes, which migrate to an n-layer and to a p-layer, respectively, thereby generating photovoltaic electricity across the p-n junction.

Since the solar cell industry as a device industry places a significant emphasis on both conversion efficiency of a device and production cost, maximizing production efficiency and reducing manufacturing costs through mass production are keys to the success of this industry. The solar cell industry is transitioning from traditional first-generation silicon-based solar cells to promising next-generation tandem solar cells manufactured by stacking perovskite solar cells.

In a thin film process for manufacturing perovskite solar cells, a process of forming a self-assembled monolayer (SAM) thin film may be required.

Typical methods for SAM coating include dip coating, in which a substrate is dipped in a solution, and spin coating, in which a solution is dropped onto a surface of a rotating substrate. However, dip coating requires an additional process to remove a solution from surface areas of a substrate where coating is not desired, as the entire substrate is dipped in the solution. In addition, despite the ability to form a uniform thin film on a substrate, spin coating can result in a relatively large amount of wasted solution due to rotational motion of the substrate.

### [Disclosure]

### [Technical Problem]

It is an object of the present invention to provide a solar cell manufacturing apparatus that eliminates the need for a separate process to remove a solution coated on unwanted areas and enables formation of a uniform thin film on a substrate, and a solar cell manufacturing method using the same.

The above object is provided by way of example and the present invention is not limited thereto.

### [Technical Solution]

In accordance with one aspect of the present invention, a solar cell manufacturing apparatus includes: a conveying unit conveying a plurality of substrates seated thereon; and a first ejection unit ejecting a coating solution onto the plurality of substrates seated on the conveying unit, wherein the conveying unit continuously conveys the plurality of substrates, the first ejection unit is disposed in a stationary manner above the conveying unit to eject the coating solution onto the plurality of substrates in the order in which the substrates are conveyed, and the conveying unit has a mesh structure.

The solar cell manufacturing apparatus may further include: a second ejection unit ejecting a cleaning solution onto the plurality of substrates seated on the conveying unit, wherein the second ejection unit is disposed in front of the first ejection unit with respect to a conveying direction of the conveying unit.

The solar cell manufacturing apparatus may further include: a second air ejection unit disposed behind the second ejection unit with respect to the conveying direction of the conveying unit to eject air onto the plurality of substrates with the cleaning solution ejected thereon.

The solar cell manufacturing apparatus may further include: a first air ejection unit disposed behind the first ejection unit with respect to a conveying direction of the conveying unit to eject air onto the plurality of substrates with the coating solution ejected thereon.

The first ejection unit may include a plurality of ejection nozzles, ejection zones of the plurality of ejection nozzles may overlap, and a region in which the ejection zones overlap may have an area corresponding to 50% or more of an area of the substrate.

The solar cell manufacturing apparatus may further include: a substrate support mounted on the conveying unit to allow the substrate to be seated thereon.

The substrate support may include a first substrate support and a second substrate support each having an inclined surface, the inclined surfaces being symmetrical to each other and facing each other with a space therebetween, and the substrate may be seated between the first substrate support and the second substrate support while making line contact with the inclined surfaces.

In accordance with another aspect of the present invention, a solar cell manufacturing method includes: placing a substrate on a conveying unit; depositing a thin film on the substrate; recovering the substrate from the conveying unit; and cleaning the conveying unit, wherein, in the step of depositing a thin film on the substrate, a self-assembled monolayer (SAM) thin film is formed on the substrate, and the step of depositing a thin film on the substrate includes: ejecting a cleaning solution onto the substrate; ejecting a first air jet onto the substrate; ejecting a coating solution onto the substrate; and ejecting a second air jet onto the substrate.

The step of cleaning the conveying unit may include: conveying the conveying unit separated from the substrate to a bath to clean the conveying unit; and drying, by a heater, the conveying unit having passed through the bath.

The conveying unit has a mesh structure, and a substrate support is mounted on the conveying unit to allow the substrate to be seated thereon.

The above and other aspects, features, and advantages of the present invention will become apparent from the detailed description, claims, and drawings for practicing the invention.

### [Advantageous Effects]

In a solar cell manufacturing apparatus and a solar cell manufacturing method according to embodiments of the present invention, a conveying unit has a mesh structure allowing an ejected coating solution to drain under the conveying unit through mesh holes without accumulating on the conveying unit, thereby eliminating the need for a separate process to remove the coating solution accumulated on the conveying unit.

In addition, the solar cell manufacturing apparatus and the solar cell manufacturing method according to the embodiments of the present invention can uniformly apply a coating solution to a substrate by a spray coating process.

The effects of the present invention are not limited to the aforementioned effects and other effects not mentioned will become apparent to those skilled in the art from the claims.

### [Description of Drawings]

FIG. 1 is a conceptual view of a solar cell manufacturing apparatus according to one embodiment of the present invention.
FIG. 2 is a plan view taken in direction A of FIG. 1.
FIG. 3 is a side view taken in direction B of FIG. 1.
FIG. 4 is a conceptual view of a solar cell manufacturing apparatus with a bath and a heater added to FIG. 1.
FIG. 5 is a cross-sectional view taken along line C-C' of FIG. 2.
FIG. 6 is a side view taken in direction D of FIG. 2.
FIG. 7 is an enlarged view of region E of FIG. 2.
FIG. 8 is a flowchart illustrating a solar cell manufacturing method according to one embodiment of the present invention.
FIG. 9 is a flowchart illustrating a thin film deposition step of the solar cell manufacturing method of FIG. 8.

### [Best Mode]

The present invention can be modified in various ways and can have various embodiments, some of which are illustrated in the drawings and described in detail in the following description of the invention. However, it should be understood that it is not intended to limit the present invention to any particular embodiments and the present invention includes all modifications, equivalents, or substitutions that fall within the scope of the present invention. In description of the invention, the same components will be denoted by the same reference numerals throughout the specification.

Hereinafter, exemplary embodiments of the present invention will be described in detail with reference to the accompanying drawings, in which the same or corresponding components will be denoted by the same reference numerals and repeated description thereof will be omitted.

In the following embodiments, the terms "first", "second", and the like are not intended to be limiting, but are used to distinguish one element from another element.

In the following embodiments, the singular forms "a", "an" and "the" are intended to include the plural forms as well, unless the context clearly indicates otherwise.

In the following embodiments, the terms "includes," "including," "comprises," and/or "comprising," when used in this specification, specify the presence of stated features or components but do not preclude the presence or addition of one or more other features or components.

In the drawings, dimensions of various elements, layers, etc. may be exaggerated or reduced for clarity of illustration. For example, the size and thickness of each element shown in the drawings is arbitrarily shown for ease of description and the present invention is not limited thereto.

When an exemplary embodiment is implemented differently, a specific process order may be performed differently from the described order. For example, two consecutively described processes may be performed substantially at the same time or performed in an order opposite the described order.

The terminology used herein is for the purpose of describing particular embodiments and is not intended to be limiting. Moreover, the terms "includes," "including," "comprises," and/or "comprising," when used in this specification, specify the presence of stated features, integers, steps, operations, elements, components and/or groups thereof but do not preclude the presence or addition of one or more other features, integers, steps, operations, elements, components, and/or groups thereof.

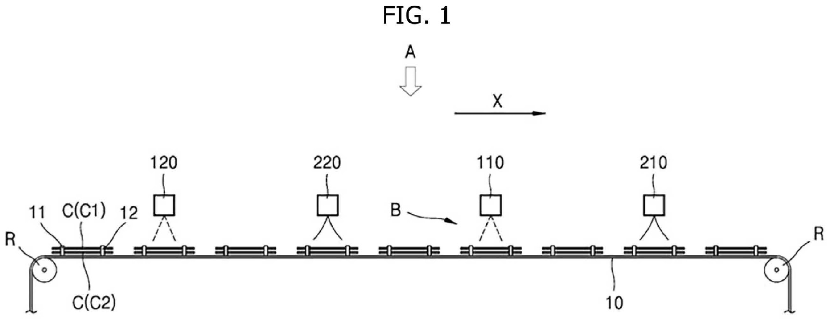

Hereinafter, a solar cell manufacturing apparatus according to one embodiment of the present invention will be described with reference to FIG. 1 to FIG. 7.

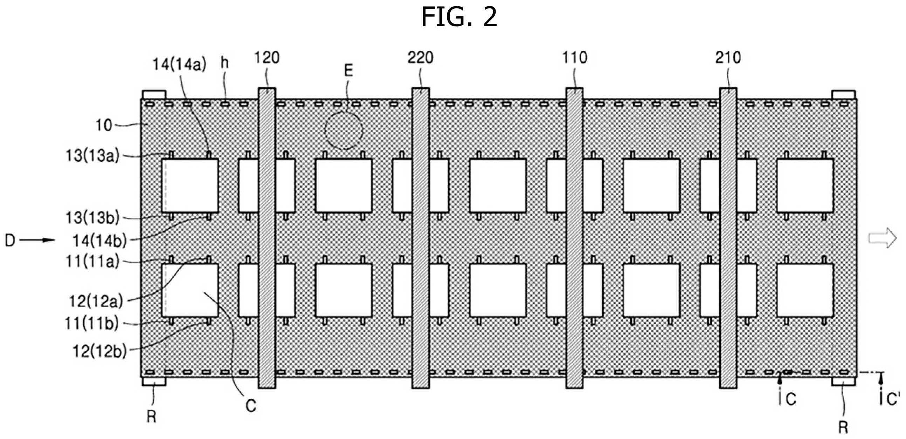

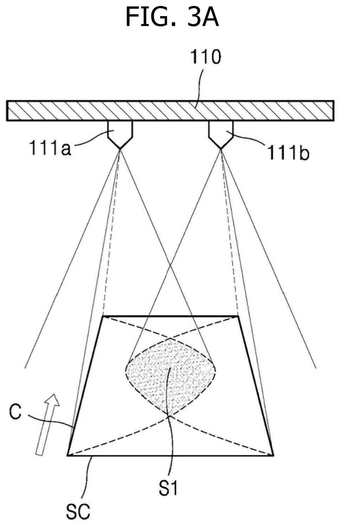

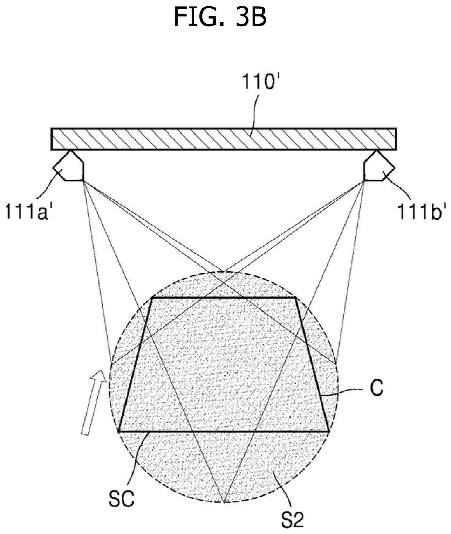

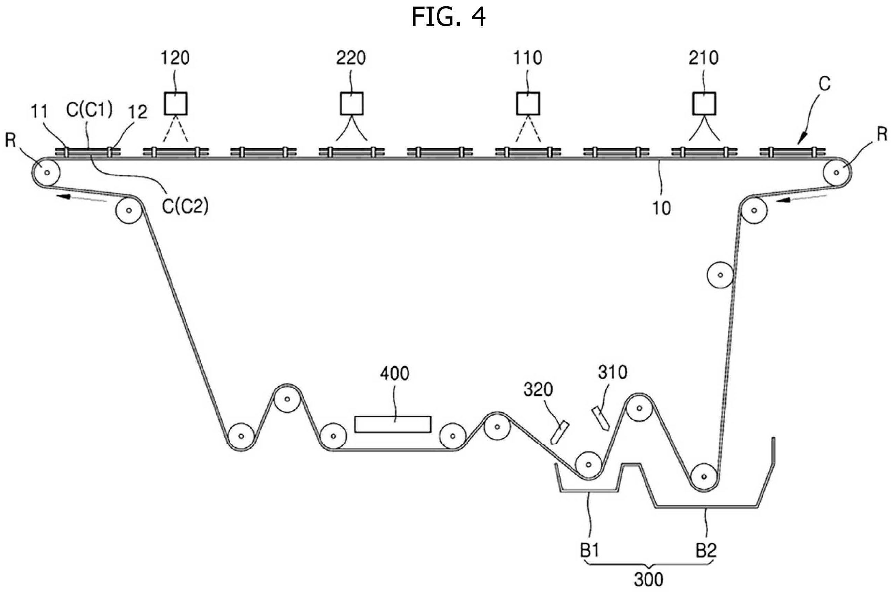

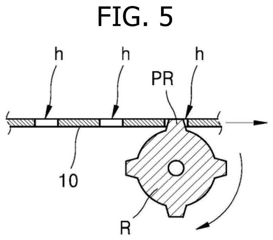

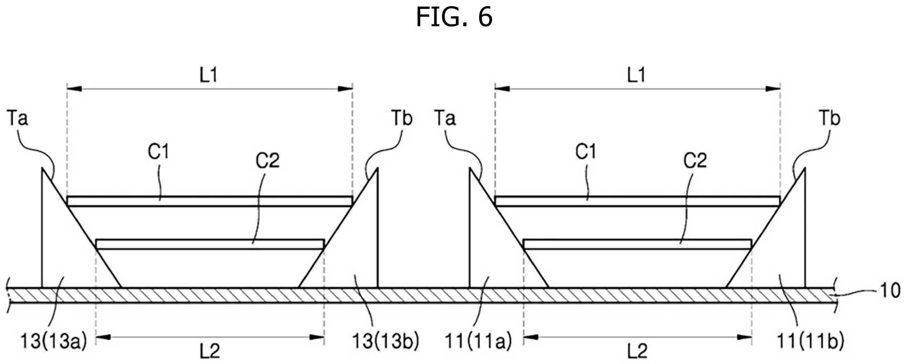

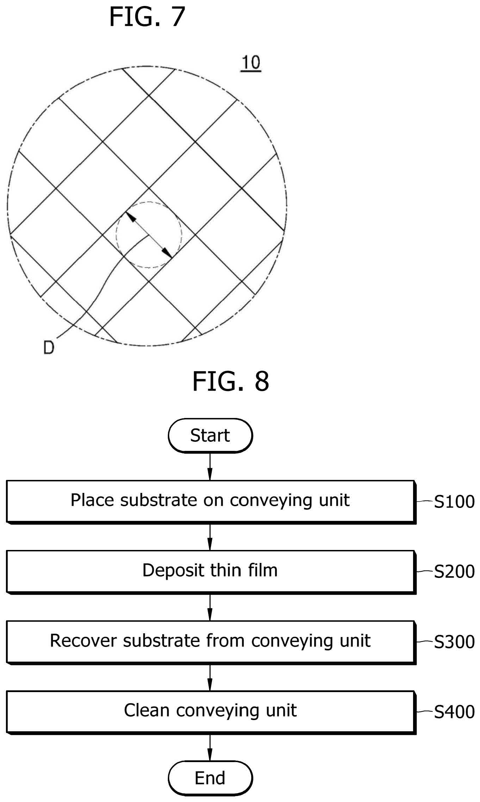

FIG. 1 is a conceptual view of a solar cell manufacturing apparatus according to one embodiment of the present invention. FIG. 2 is a plan view taken in direction A of FIG. 1. FIG. 3 is a side view taken in direction B of FIG. 1. FIG. 4 is a conceptual view of a solar cell manufacturing apparatus with a bath and a heater added to FIG. 1. FIG. 5 is a cross-sectional view taken along line C-C' of FIG. 2. FIG. 6 is a side view taken in direction D of FIG. 2. FIG. 7 is an enlarged view of region E of FIG. 2.

Referring to FIG. 1 to FIG. 7, the solar cell manufacturing apparatus according to the embodiment of the present invention includes a conveying unit 10 conveying a plurality of substrates C seated thereon; and a first ejection unit 110 spraying a coating solution onto the plurality of substrates C seated on the conveying unit 10.

Here, the conveying unit 10 continuously conveys the plurality of substrates C, and the first ejection unit 110 is disposed in a stationary manner above the conveying unit 10 to eject the coating solution onto the plurality of substrates C conveyed continuously in the order in which the substrates are conveyed. The conveying unit 10 has a mesh structure.

The conveying unit 10 may include a conveyor belt. The conveying unit 10 is wound on a roller unit R. The conveying unit 10 may convey the plurality of substrates C seated thereon by being moved by rotation of the roller unit R. The substrate C may be, for example, a wafer.

According to this embodiment, the first ejection unit 110 may form a thin film coating on the substrate C by ejection coating. Here, the first ejection unit 110 may form a thin film coating on the substrate C by atomization coating. Specifically, the first ejection unit 110 may atomize the coating solution into mist and apply the atomized coating solution to a surface of a target substrate C.

Since the first ejection unit 110 can perform a thin film coating process using atomization, the first ejection unit 110 facilitates adjustment of thickness of a thin film even with a small amount of coating solution. Furthermore, the first ejection unit 110 enables deposition of a uniform thin film even on a substrate having a step, unevenness, or curvature on a surface thereof.

According to this embodiment, the first ejection unit 110 may form a self-assembled monolayer (SAM) on the surface of the substrate C by spray coating. For example, a SAM material may include 2PACz, MeO-2PACz, Me-4PACx, Me-2PACz, and the like, which may be dissolved in a solvent (for example, ethanol) prior to application.

According to this embodiment, the conveying unit 10 may continuously convey the plurality of substrates C, and the first ejection unit 110 is disposed in a stationary manner above the conveying unit 10 to eject the coating solution onto the plurality of substrates C conveyed continuously in the order in which the substrates C are conveyed.

That is, in this embodiment, instead of the ejection unit approaching each individual substrate C to perform a thin film coating process for each substrate, the ejection unit is stationary and the plurality of substrates C is continuously conveyed to a region where the ejection unit ejects the coating solution, thereby enabling a continuous coating process.

As such, since the plurality of substrates C continuously conveyed are continuously coated while passing through the stationary ejection unit, the thin-film coating process can be effectively performed with minimal power. According to this embodiment, the ejection unit may be a sprayer. The ejection unit in the form of a sprayer may apply the coating solution to the substrate by spraying.

In addition, according to this embodiment, since the conveying unit 10 has a mesh structure, the ejected coating solution can drain under the conveying unit 10 through holes of the mesh structure without accumulating on the conveying unit 10, thereby eliminating the need for a separate process to remove the coating solution accumulated on the conveying unit 10.

According to this embodiment, the solar cell manufacturing apparatus may further include a first air ejection unit 210 disposed behind the first ejection unit 110 with respect to a conveying direction X of the conveying unit 10 to eject air onto the plurality of substrates C with the coating solution thereon.

In addition, according to this embodiment, the solar cell manufacturing apparatus may further include a second ejection unit 120 ejecting a cleaning solution onto the plurality of substrates C seated on the conveying unit 10, wherein the second ejection unit 120 may be disposed in front of the first ejection unit 110 with respect to the conveying direction X of the conveying unit 10. In addition, the solar cell manufacturing apparatus may further include a second air ejection unit 220 disposed behind the second ejection unit 120 with respect to the conveying direction X of the conveying unit 10 to eject air onto the plurality of substrates C with the cleaning solution thereon.

The substrate C may first pass through an ejection zone of the second ejection unit 120. Here, the second ejection unit 120 may eject a cleaning solution onto the substrate C. That is, the second ejection unit 120 may rinse the substrate C. The second ejection unit 120 may eject a cleaning solution such as ethanol onto the substrate C by an air spray method. The cleaning solution ejected onto the substrate C may volatilize together with organic matter on the surface of the substrate C.

After passing through the ejection zone of the second ejection unit 120, the substrate C may pass through an ejection zone of the second air ejection unit 220. Here, the second air ejection unit 220 may supply air to dry a residual solution remaining on the surface of the substrate C after the cleaning solution ejected through the second ejection unit 120 volatilizes together with organic matter on the surface of the substrate C, thereby removing the residual solution from the substrate C.

For example, the second air ejection unit 220 may include an air knife. The air knife may supply dry air to the surface of the substrate C to evaporate the residual solution on the surface of the substrate C. Here, the dry air supplied by the air knife may include argon (Ar) or nitrogen (N₂). In addition, the air knife may include a heater built therein to supply dry air to the surface of the substrate C. The built-in heater may increase the temperature of the dry air to accelerate evaporation of the residual solution.

After the cleaning process through the second ejection unit 120 and the second air ejection unit 220 is complete, the substrate C may be subjected to a thin film coating process through the first ejection unit 110. Here, the first ejection unit 110 may atomize a coating solution and eject the atomized coating solution onto the substrate C to form a SAM thin film on the substrate C. Here, the coating solution may be a solvent containing a material for forming the SAM thin film.

Here, the first ejection unit 110 may include an ultrasonic spray nozzle or a pulse sprayer to minimize waste caused by splashing or scattering of droplets, especially considering high cost of the SAM thin film coating process.

After the thin film coating process through the first ejection unit 110 is complete, the first air ejection unit 210 may perform a drying process to dry the solvent on the thin film.

In the coating process for forming the SAM thin film as in this embodiment, the properties of the thin film can vary depending on the time required for evaporation of the solvent containing the SAM material coated on the substrate C. Accordingly, in this embodiment, to form the SAM thin film, the second ejection unit 120, the second air ejection unit 220, the first ejection unit 110, and the first air ejection unit 210 are sequentially disposed in a stationary manner at respective designated positions and the conveying unit 10 continuously conveys the plurality of substrates C in a predetermined time sequence such that the plurality of substrates C sequentially passes through the second ejection unit 120, the second air ejection unit 220, the first ejection unit 110, and the first air ejection unit 210 to be sequentially subjected to each ejection process at regular time intervals, thereby ensuring that the properties of the deposited thin film remain consistent throughout all the substrates C.

According to the present embodiment, the first ejection unit 110 may include a plurality of ejection nozzles 111a, 111b, as shown in FIG. 3. Here, ejection zones of the plurality of ejection nozzles (111a, 111b; 111a', 111b') may form an overlapped ejection zone S1; S2, wherein the overlapped ejection zone S1; S2 may have an area corresponding to 50% or more of a substrate area SC. If the area of the overlapped ejection zone S1; S2 is less than 50% of the substrate area SC, it can be difficult to achieve deposition of a uniform thin film.

As such, to obtain a uniform thin film coating, the distance between the ejection nozzles and the angle of each of the nozzles may be adjusted to secure an overlapped ejection zone while ensuring deposition of a uniform thin film.

Although the first ejection unit is shown as including two ejection nozzles in FIG. 3, the number of ejection nozzles is not limited thereto. A plurality of ejection nozzles adjusted in relative positions, intervals, and angles may be provided to eject a coating solution containing the SAM material onto the substrate C so as to achieve deposition of a uniform thin film.

FIG. 3(a) shows a case where the first ejection unit 110 includes a plurality of ejection nozzles 111a, 111b and an overlapped ejection zone S1 formed by the plurality of ejection nozzles 111a, 111b has an area corresponding to 50% of the substrate area SC.

Fig. 3(b) shows a case where a first ejection unit 110' includes a plurality of ejection nozzles 111a', 111b' and an overlapped ejection zone S2 formed by the plurality of ejection nozzles 111a', 111b' has an area corresponding to 100% or more of the substrate area SC.

Referring to FIG. 2 and FIG. 6, the solar cell manufacturing apparatus may include substrate supports 11, 12, 13, 14 mounted on the conveying unit 10 to allow the substrate C to be seated thereon. The substrate C seated on the substrate supports 11, 12, 13, 14 may be spaced apart from the conveying unit 10.

If the substrate contacts the conveying unit, the coating solution, the cleaning solution, or the like ejected onto the substrate can be transferred to the substrate while staying between the substrate and the conveying unit, causing contamination of the substrate. To address this issue, according to this embodiment, the substrate C is seated on the substrate supports 11, 12, 13, 14, rather than directly on the conveying unit 10, such that the substrate C can be spaced apart from the conveying unit 10 by the substrate supports 11, 12, 13, 14.

Some of the coating solution or the cleaning solution ejected onto the substrate C drops down from the substrate C and then is discharged to a space under the conveying unit 10 through the mesh holes of the conveying unit 10 spaced apart from the substrate C. According to this embodiment, each of the mesh holes may have a diameter D of about 1 cm to about 5 cm (for example, 1 cm, 2 cm, 3 cm, 4 cm, or 5 cm), as shown in FIG. 7. If the diameter D of the mesh hole is less than 1 cm, the coating solution or the cleaning solution cannot pass through the mesh holes due to surface tension and thus can accumulate on a surface of the mesh structure, rather than draining under the conveying unit 10 through the mesh holes. If the diameter D of the mesh hole exceeds 5 cm, it can be difficult to securely couple the substrate supports 11, 12, 13, 14 to the conveying unit 10.

According to this embodiment, the substrate support 11; 12; 13; 14 includes a first substrate support 11a; 12a; 13a; 14a and a second substrate support 11b; 12b; 13b; 14b each having an inclined surface, wherein the two inclined surfaces are symmetrical to each other and face each other with a space therebetween, and the substrate C may be seated between the first substrate support 11a; 12a; 13a; 14a and the second substrate support 11b; 12b; 13b; 14b while making line contact with the inclined surfaces Ta, Tb. As such, since the substrate C makes line contact with the inclined surfaces Ta, Tb to minimize a contact area between the substrate C and the first and second substrate supports, it is possible to prevent contamination of the substrate C due to stagnation of the coating solution, the cleaning solution, and the like ejected on a wafer.

Each of the substrate supports 11, 12, 13, 14 has a right-angled triangular shape, wherein one of the two edges including the right angle of the right-angled triangular shape may be coupled to the conveying unit 10. The first substrate support 11a; 12a; 13a; 14a and the second substrate support 11b; 12b; 13b; 14b constituting the substrate support 11; 12; 13; 14 may be spaced apart from each other on the conveying unit 10 in a direction which the respective inclined surfaces thereof face each other.

The substrate C may be disposed between the inclined surfaces Ta, Tb facing each other to be seated thereon. One edge of the substrate C may make line contact with one inclined surface Ta, and the other edge of the substrate facing the one edge may make line contact with the other inclined surface Tb. The substrate C may be fitted between the inclined surfaces Ta, Tb facing each other to be securely held against the first substrate support 11a; 12a; 13a; 14a and the second substrate support 11b; 12b; 13b; 14b. In this way, it is possible to prevent the substrate C from meandering during conveyance of the substrate C through the conveying unit 10.

According to this embodiment, a plurality of substrates C1, C2 may be seated between the first substrate support 11a; 12a; 13a; 14a and the second substrate support 11b; 12b; 13b; 14b, as shown in FIG. 6, wherein the plurality of substrates C1 , C2 may have different lengths.

The first substrate support 11a; 12a; 13a; 14a and the second substrate support 11b; 12b; 13b; 14b have respective inclined surfaces Ta, Tb facing each other, and a gap between the first substrate support 11a; 12a; 13a; 14a and the second substrate support 11b; 12b; 13b; 14b may become narrower downward. Accordingly, a first substrate C1 having a first length L1 (a relatively longer length) may be seated on the inclined surfaces Ta, Tb of the first substrate support 11a; 12a; 13a; 14a and the second substrate support 11b; 12b; 13b; 14b at a location above a second substrate C2 having a second length L2 (a relatively shorter length).

The substrate supports 11, 12, 13, 14 may be coupled to the conveying unit 10 through an adhesive, or may be coupled to the conveying unit 10 through a coupling member, such as a hook, wire, or the like.

For example, the substrate supports 11, 12, 13, 14 may be detachably coupled to the conveying unit 10. Accordingly, after conveyance of the substrates C is complete, the substrate supports 11, 12, 13, 14 may be removed from the conveying unit 10, which, in turn, may be subjected to cleaning and drying processes while passing through a bath and a heater described below.

The plurality of substrates C may be arranged in two rows in the conveying direction X of the conveying unit 10. For one row of substrates C among the two rows of substrates, a 1^{st} first substrate support 11a and a 1^{st} second substrate support 11b may form a pair to support one side of the substrate C from both directions. In addition, a 2^{nd} first substrate support 12a and a 2^{nd} second substrate support 12b may form a pair to support the other side of the substrate C from both directions.

For the other row of substrates C, a 3^{rd} first substrate support and a 3^{rd} second substrate support 13b may form a pair to support one side of the substrate C from both directions. In addition, a 4^{th} first substrate support 14a and a 4^{th} second substrate support 14b may form a pair to support the other side of the substrate C from both directions.

Here, a direction in which the two inclined surfaces of each of the substrate supports 11, 12, 13, 14 face each other may be perpendicular to the conveying direction X of the conveying unit 10. Here, a longitudinal direction of each of the substrate supports 11, 12, 13, 14 may also be perpendicular to the conveying direction X of the conveying unit 10, such that the substrate supports 11, 12, 13, 14 can be conveyed together with the conveying unit 10 in a state of being coupled to the conveying unit 10 when the conveying unit 10 is wound by a roller unit R described below.

Although the plurality of substrates C is described as being arranged in two rows, it should be understood that the plurality of substrates C may be arranged in three or more rows. Additionally, the number of substrate supports supporting the substrate C may be increased or decreased with respect to the four substrate supports.

According to this embodiment, a plurality of holes h may be arranged along both edges of the conveying unit 10 parallel to the conveying direction X, and a toothed roller unit R configured to be engaged with the plurality of holes h may be provided to convey the conveying unit. Specifically, the conveying unit 10 may be conveyed as the roller unit R is rotated such that teeth RR of the roller unit R are sequentially inserted into the plurality of holes h.

As such, by conveying the conveying unit 10 using the plurality of holes h formed in the conveying unit 10 and the toothed structure of the roller unit R, it is possible to prevent the conveying unit 10 from meandering.

Referring to FIG. 4, the solar cell manufacturing apparatus may further include a bath 300 cleaning the conveying unit 10 and a heater 400 drying the conveying unit 10 having passed through the bath 300.

After passing through the ejection zones of the first ejection unit 110 and the second ejection unit 110, 210, the surface of the conveying unit 10 can remain coated with the ejected solutions. If the conveying unit with the ejected solutions adhered thereto is reused without cleaning, the previously ejected solutions can be transferred to the next substrate, causing contamination of the corresponding substrate.

According to this embodiment, after the thin film deposition process through conveyance of the substrate C is complete, the conveying unit 10 may be conveyed to the bath 300 by the roller unit R to be cleaned in the bath 300. For example, the bath 300 may include a plurality of baths B1, B2. Each of the plurality of baths B1, B2 may contain a conveying unit cleaning solution. The conveying unit 10 may be cleaned by being dipped in the plurality of baths B1, B2. A plurality of air ejection units 310, 320 may be disposed near the bath 300 to remove the cleaning solution adhered to the conveying unit 10 in the bath 300.

The conveying unit 10 having passed through the bath 300 may be dried while passing through the heater 400. On the conveying unit 10 having passed through the bath 300 and the heater 400 and thus being in a decontaminated state, new substrates C may be seated such that the thin film deposition process is continuously performed by forcing the substrates C to sequentially pass through the second ejection unit 120, the second air ejection unit 220, the first ejection unit 110, and the first air ejection unit 210 by movement of the conveying unit 10.

As such, as the conveying unit 10 is circulated on a conveyor mechanism by the roller unit R, film deposition on the substrate C can be carried out through a continuous process.

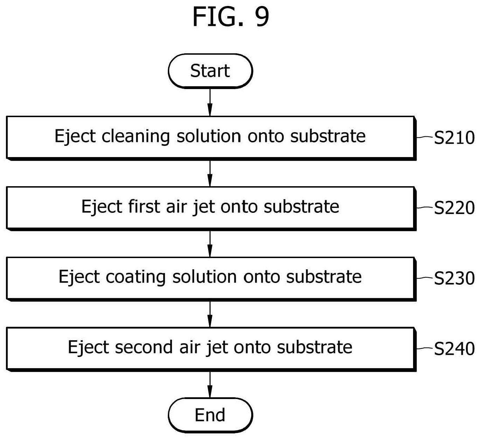

Next, a solar cell manufacturing method according to one embodiment of the present invention will be described with reference to FIG. 8 and FIG. 9. For details not shown in FIG. 8 and FIG. 9, refer to the description given above with reference to FIG. 1 to FIG. 5.

FIG. 8 and FIG. 9 are flowcharts illustrating a solar cell manufacturing method according to one embodiment of the present invention.

Referring to FIG. 8 and FIG. 9, the solar cell manufacturing method according to this embodiment may include: placing a substrate on a conveying unit (S100); depositing a thin film on the substrate (S200); recovering the substrate from the conveying unit (S330), and cleaning the conveying unit (S400).

The step of placing a substrate on a conveying unit (S100) may be a step of placing a substrate C on a conveying unit 10 to form a predetermined thin film on the substrate C. In step S100, the substrate C may be placed at a designated location, for example, on substrate supports 11, 12, 13, 14.

The step of depositing a thin film (S200) may be a step of forming a predetermined thin film on the substrate C. For example, the step of depositing a thin film (S200) may be a step of forming a self-assembled monolayer (SAM) thin film on the substrate C. For example, a SAM material may include 2PACz, MeO 2PACz, Me 4PACx, Me-2PACz, and the like, which may be dissolved in a solvent prior to application.

The step of depositing a thin film (S200) may include: ejecting a cleaning solution onto the substrate (S210), ejecting a first air jet onto the substrate (S220), ejecting a coating solution onto the substrate (S230), and ejecting a second air jet onto the substrate (S240).

The step of ejecting a cleaning solution onto the substrate (S210) may be a step of ejecting, by a second ejection unit 120, a cleaning solution onto a plurality of substrates C seated on the conveying unit 10. The step of ejecting a first air jet onto the substrate (S220) may be a step of ejecting, by a second air ejection unit 220, a first air jet onto the plurality of substrates C with the cleaning solution ejected thereon. The step of ejecting a coating solution onto the substrate (S230) may be a step of ejecting, by a first ejection unit 110, a coating solution onto the plurality of substrates C seated on the conveying unit 10. The step of ejecting a second air jet onto the substrate (S240) may be a step of ejecting, by a first air ejection unit 210, a second air jet onto the plurality of substrates C with the coating solution ejected thereon. Here, the first air jet and the second air jet may be identical to each other.

Subsequently, the step of recovering the substrate from the conveying unit (S300) may be performed. The step of recovering the substrate from the conveying unit may be a step of separating the plurality of substrates C from the conveying unit 10. In step S300, the substrate C placed on the substrate supports 11, 12, 13, 14 may be conveyed to a designated area.

Subsequently, the step of cleaning the conveying unit (S400) may be performed. The step of cleaning the conveying unit (S400) may be a step of removing a residue remaining on the conveying unit 10 after the SAM thin film deposition process is complete.

The step of cleaning the conveying unit (S400) may include: conveying the conveying unit 10 separated from the plurality of substrates C to a bath 300 to clean the conveying unit 10; and drying, by a heater 400, the conveying unit 10 having passed through the bath 300, after the step of ejecting, by the first air ejection unit 210, air onto the plurality of substrates C with the coating solution ejected thereon. In this way, effective cleaning of the conveying unit 10 having a mesh structure can be achieved. In addition, it is possible to prevent reduction in quality of thin film deposition on cells C placed on the conveying unit 10 due to impurities remaining on the conveying unit 10 when the thin film deposition process is re-conducted through circulation of the conveying unit 10.

In addition, given that the substrate support portions 11, 12, 13, 14 may be detachably coupled to the conveying unit 10, the solar cell manufacturing method may further include: conveying the plurality of substrates C separately from the conveying unit 10; and separating the substrate support portions 11, 12, 13, 14 from the conveying unit 10, before the step of conveying the conveying unit 10 separated from the plurality of substrates C to the bath 300 to clean the conveying unit 10.

Although the present invention has been described with reference to the embodiments and the drawings, it should be understood that these embodiments are provided by way of illustration only and that various modifications, changes, and alterations can be made without departing from the spirit and scope of the invention. The scope of the invention should be defined by the appended claims.

Specific technical details described in the embodiments are provided by way of example and do not limit the scope of the invention. In order to make the description of the invention concise and clear, descriptions of typical techniques and configurations in the art may be omitted. In addition, connections of lines or connection members between components shown in the drawings are given for illustration of functional connections and/or physical or circuit connections, which may be represented by various alternative or additional functional connections, physical connections, or circuit connections in an actual device. Furthermore, components may not be required for application of the present invention unless specifically stated as "essential," "important," or the like.

The word "the" or similar directives in the description and claims of the invention may refer to both singular and plural, unless otherwise specified. Furthermore, when a range is recited in an embodiment, it is intended to include the invention with individual values within the range (unless indicated otherwise) and means that each individual value constituting the range is recited in the description of the invention. In addition, the steps constituting a method according to an embodiment may be performed in any suitable order, unless an explicit order is stated or unless indicated otherwise. It should be understood that embodiments are not necessarily limited by the order in which the steps are described. The use of any examples or exemplary terms (for example, "and the like") in the embodiments is intended merely to describe the embodiments in detail and is not intended to limit the scope of the embodiments, unless limited by the claims. Furthermore, a person having ordinary knowledge in the art will recognize that various modifications, combinations, alterations, and changes can be made in accordance with design conditions and factors within the scope of the appended claims or equivalents thereto.

## Claims

1. A solar cell manufacturing apparatus comprising:
a conveying unit conveying a plurality of substrates seated thereon; and
a first ejection unit ejecting a coating solution onto the plurality of substrates seated on the conveying unit,
wherein the conveying unit continuously conveys the plurality of substrates,
the first ejection unit is disposed in a stationary manner above the conveying unit to eject the coating solution onto the plurality of substrates in the order in which the substrates are conveyed, and
the conveying unit has a mesh structure.

2. The solar cell manufacturing apparatus according to claim 1, further comprising:
a second ejection unit ejecting a cleaning solution onto the plurality of substrates seated on the conveying unit,
wherein the second ejection unit is disposed in front of the first ejection unit with respect to a conveying direction of the conveying unit.

3. The solar cell manufacturing apparatus according to claim 2, further comprising:
a second air ejection unit disposed behind the second ejection unit with respect to the conveying direction of the conveying unit and ejecting air onto the plurality of substrates with the cleaning solution ejected thereon.

4. The solar cell manufacturing apparatus according to claim 1, further comprising:
a first air ejection unit disposed behind the first ejection unit with respect to a conveying direction of the conveying unit and ejecting air onto the plurality of substrates with the coating solution ejected thereon.

5. The solar cell manufacturing apparatus according to claim 1, wherein
the first ejection unit comprises a plurality of ejection nozzles,
ejection zones of the plurality of ejection nozzles overlap, and
a region in which the ejection zones overlap has an area corresponding to 50% or more of an area of the substrate.

6. The solar cell manufacturing apparatus according to claim 1, further comprising:
a substrate support mounted on the conveying unit to allow the substrate to be seated thereon.

7. The solar cell manufacturing apparatus according to claim 6, wherein
the substrate support comprises a first substrate support and a second substrate support each having an inclined surface, the inclined surfaces being symmetrical to each other and facing each other with a space therebetween, and
the substrate is seated between the first substrate support and the second substrate support while making line contact with the inclined surfaces.

8. A solar cell manufacturing method comprising:
placing a substrate on a conveying unit;
depositing a thin film on the substrate;
recovering the substrate from the conveying unit; and
cleaning the conveying unit,
wherein, in the step of depositing a thin film on the substrate, a self-assembled monolayer (SAM) thin film is formed on the substrate, and
the step of depositing a thin film on the substrate comprises:
ejecting a cleaning solution onto the substrate;
ejecting a first air jet onto the substrate;
ejecting a coating solution onto the substrate; and
ejecting a second air jet onto the substrate.

9. The solar cell manufacturing method according to claim 8, wherein
the step of cleaning the conveying unit comprises:
conveying the conveying unit separated from the substrate to a bath to clean the conveying unit; and
drying, by a heater, the conveying unit having passed through the bath.

10. The solar cell manufacturing method according to claim 8, wherein
the conveying unit has a mesh structure, and
a substrate support is mounted on the conveying unit to allow the substrate to be seated thereon.
